# EUROPEAN PATENT APPLICATION

(11) **EP 2 849 233 A1**
(43) Date of publication of application: **18.03.2015**
(21) Application number: 14184547.9
(22) Date of filing: 12.09.2014
(51) Int. Cl.: H01L 31/0224, H01L 31/0747

(54) **Solar cell**

(30) Priority: 17.09.2013 JP 2013191532
(71) Applicant: Sanyo Electric Co., Ltd., Moriguchi-shi, Osaka 570-8677 (JP)
(72) Inventor: Narita, Tomoki, Moriguchi City, Osaka 570-8677 (JP)
(74) Representative: Glawe, Delfs, Moll

(57) **Abstract**

A solar cell includes: a crystalline silicon substrate of one conductivity type including a first principal surface, and a second principal surface provided on an opposite side from the first principal surface; a first amorphous silicon layer of the other conductivity type provided on the first principal surface side; a second amorphous silicon layer of the one conductivity type provided on the second principal surface side; a contact layer in contact with the second amorphous silicon layer; a magnesium-doped zinc oxide layer in contact with the contact layer; a first electrode layer provided on the first amorphous silicon layer; and a second electrode layer provided on the magnesium-doped zinc oxide layer. A lattice constant of the contact layer is within a range of plus or minus 30% relative to a lattice constant of the magnesium-doped zinc oxide layer.

## Description

### CROSS REFERENCE TO RELATED APPLICATIONS

This application claims priority from prior Japanese Patent Applications No. 2013-191532, filed on September 17, 2013, entitled "SOLAR CELL", the entire contents of which are incorporated herein by reference.

### BACKGROUND OF THE INVENTION

### Field of the Invention

This disclosure relates to a solar cell.

### Description of Related Art

A solar cell generally includes a photoelectric conversion body, which is provided between a transparent electrode layer placed on a light incident side and a back surface electrode layer placed on the opposite side from the light incident side. In order to enhance photoelectric conversion efficiency of the solar cell, there is a proposal to provide a reflection layer between the photoelectric conversion body and the back surface electrode so as to reflect part of the incident light (See International Patent Application Publication No. WO2012/105146).

### SUMMARY OF THE INVENTION

An object of an embodiment of the invention is to provide a solar cell which can enhance photoelectric conversion efficiency.

An aspect of the invention is a solar cell that includes: a crystalline silicon substrate including a first principal surface, and a second principal surface provided on an opposite side from the first principal surface; a first amorphous silicon layer provided on the first principal surface side; a second amorphous silicon layer provided on the second principal surface side; a contact layer in contact with the second amorphous silicon layer; a magnesium-doped zinc oxide layer in contact with the contact layer; a first electrode layer provided on the first amorphous silicon layer; and a second electrode layer provided on the magnesium-doped zinc oxide layer. A lattice constant of the contact layer is within a range of plus or minus 30% relative to a lattice constant of the magnesium-doped zinc oxide layer.

The above aspect of the invention can enhance photoelectric conversion efficiency.

### BRIEF DESCRIPTION OF THE DRAWINGS

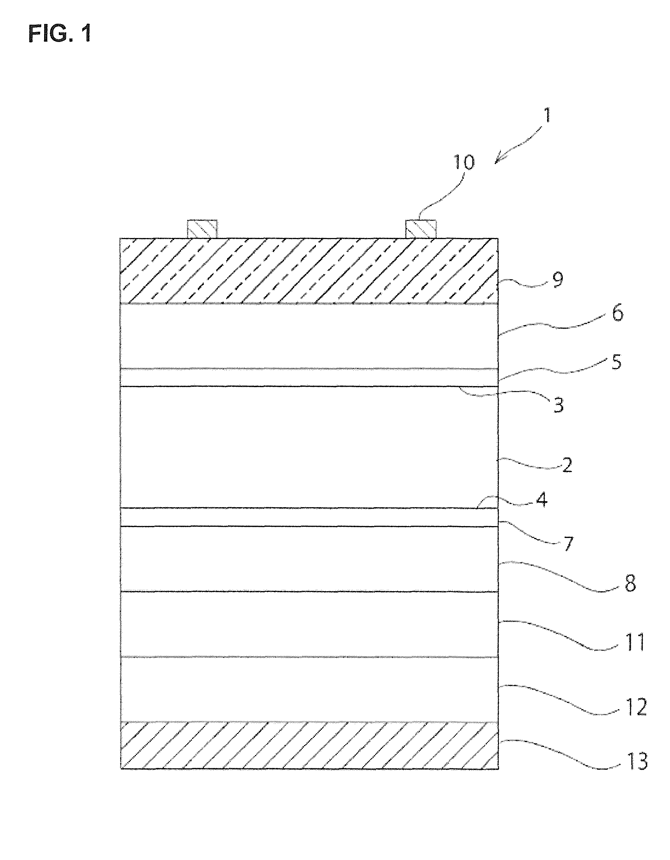

Fig. 1 is a schematic cross-sectional view illustrating a stacked structure of a solar cell of a first embodiment.

### DESCRIPTION OF EMBODIMENTS

A preferred embodiment of the invention is described below. It is to be noted, however, that the following embodiment is a mere example and the invention is not limited only to the embodiment. In the drawing, components having virtually the same functions may be referred to by using the same reference numerals when appropriate.

Fig. 1 is a schematic cross-sectional view illustrating a stacked structure of a solar cell of a first embodiment. Solar cell 1 illustrated in Fig. 1 includes crystalline silicon substrate 2 of one conductivity type. Crystalline silicon substrate 2 of the one conductivity type includes first principal surface 3 and second principal surface 4. Intrinsic amorphous silicon film 5 is formed on first principal surface 3. First amorphous silicon film 6 of the other conductivity type is formed on amorphous silicon film 5. Light-receiving surface electrode layer 9 as a first electrode layer is formed on first amorphous silicon film 6 of the other conductivity type. Finger electrodes 10 are formed on light-receiving surface electrode layer 9.

Intrinsic amorphous silicon film 7 is formed on second principal surface 4 of crystalline silicon substrate 2. Second amorphous silicon film 8 of the one conductivity type is formed on intrinsic amorphous silicon film 7. Contact layer 11 is formed on, and in such a way as to be in contact with, second amorphous silicon film 8. Mg-doped zinc oxide layer 12 is formed on, and in such a way as to be in contact with, contact layer 11. Back surface electrode layer 13 as a second electrode layer is formed on, and in such a way as to be in contact with, Mg-doped zinc oxide layer 12. Here, contact layer 11 is a layer to be inserted for the purpose of reducing a contact resistance value between second amorphous silicon film 8 and Mg-doped zinc oxide layer 12.

Crystalline silicon substrate 2 may be made of single-crystal silicon or polycrystalline silicon. Meanwhile, in this specification, the term "amorphous silicon" also includes microcrystalline silicon. The microcrystalline silicon is a sort of amorphous silicon in which silicon crystals are precipitated.

The following description is given of the case in which the conductivity type of crystalline silicon substrate 2 is the n-type, the conductivity type of first amorphous silicon film 6 is the p-type, and the conductivity type of second amorphous silicon film 8 is the n-type.

It is preferable that the dopant concentration in p-type amorphous silicon film 6 be higher than that in i-type (intrinsic) amorphous silicon film 5 and be equal to or above 1 × 10²⁰ cm⁻³. Meanwhile, it is preferable that the thickness of p-type amorphous silicon film 6 be small enough to minimize light absorption, and large enough for carriers generated by the photoelectric conversion body to be effectively separated at the junction and for the carriers to be efficiently collected with light-receiving surface electrode layer 9. Specifically, the thickness of p-type amorphous silicon layer 6 is preferably in a range from 1 nm to 50 nm inclusive.

It is preferable that the dopant concentration in n-type amorphous silicon film 8 be higher than that in i-type (intrinsic) amorphous silicon film 7 and be equal to or above 1 × 10²⁰ cm⁻³. Meanwhile, it is preferable that the thickness of n-type amorphous silicon film 8 be large enough for carriers generated inside crystalline silicon substrate 2 to be effectively separated at the junction and for the carriers to be efficiently collected with back surface electrode layer 13. Specifically, the thickness of n-type amorphous silicon layer 8 is preferably in a range from 1 nm to 50 nm inclusive.

The p-type or n-type dopant concentration in each i-type (intrinsic) amorphous silicon film 5 or 7 is preferably equal to or below 5 × 10¹⁸ cm⁻³. Meanwhile, it is preferable that the thickness of amorphous silicon films 5 and 7 be small enough to inhibit light absorption, and large enough for the surface of crystalline silicon substrate 2 to be sufficiently passivated. Specifically, the thickness is preferably in a range from 1 nm to 25 nm inclusive, or more preferably in a range from 2 nm to 10 nm inclusive.

The lattice constant of contact layer 11 is within a range of plus or minus 30% relative to the lattice constant of Mg-doped zinc oxide layer 12, or preferably within a range of plus or minus 10% relative to it, or more preferably within a range of plus or minus 5% relative to it. In this respect, the lattice constant mentioned above refers to the lattice constant in an a-axis direction. By setting the lattice constant of contact layer 11 within any of the above-mentioned ranges, it is possible to suppress a reduction in the fill factor (F.F.) and to improve a short-circuit current (Isc). Thus, the photoelectric conversion efficiency can be enhanced.

Contact layer 11 is preferably a zinc oxide layer, or more preferably a zinc oxide layer doped with Ga (gallium) or Al (aluminum). In the embodiment, contact layer 11 is a Ga-doped zinc oxide layer. The Ga content in the Ga-doped zinc oxide layer is preferably in a range from 0.1 at% to 10 at% inclusive, or more preferably in a range from 0.5 at% to 5 at% inclusive. By setting the Ga content within any of the above-mentioned ranges, it is possible to suppress an increase in electrical resistance while inhibiting absorption of the incident light.

The thickness of contact layer 11 is preferably in a range from 10 nm to 80 nm inclusive, or more preferably in a range from 20 nm to 50 nm inclusive. By setting the thickness of contact layer 11 within any of the above-mentioned ranges, it is possible to suppress an increase in contact resistance while inhibiting absorption of the incident light.

Mg-doped zinc oxide layer 12 functions as a low refractive index layer in the embodiment. The refractive index of Mg-doped zinc oxide layer 12 is preferably in a range from 1.7 to 1.9 inclusive. The Mg content in Mg-doped zinc oxide layer 12 is preferably greater than 0 at% but not exceeding 25 at%, or more preferably greater than 0 at% but not exceeding 15 at%. By setting the Mg content within any of the above-mentioned ranges, it is possible to suppress an increase in electrical resistance while inhibiting absorption of the incident light.

Mg-doped zinc oxide layer 12 may further be doped with Al.

The thickness of Mg-doped zinc oxide layer 12 is preferably in a range from 30 nm to 120 nm inclusive, or more preferably in a range from 40 nm to 80 nm inclusive. By setting the thickness of Mg-doped zinc oxide layer 12 within any of the above-mentioned ranges, it is possible to suppress an increase in electrical resistance while inhibiting absorption of the incident light.

By inserting contact layer 11 between second amorphous silicon film 8 and Mg-doped zinc oxide layer 12, the contact resistance value between contact layer 11 and second amorphous silicon film 8 can be made smaller than the contact resistance value between second amorphous silicon film 8 and Mg-doped zinc oxide layer 12. In the embodiment, an interface between contact layer 11 and Mg-doped zinc oxide layer 12 functions as a reflection layer. Accordingly, the light passing through the photoelectric conversion body inclusive of crystalline silicon substrate 2 can be reflected by the reflection layer and made incident onto the photoelectric conversion body again. This makes it possible to improve the short-circuit current (Isc) and to enhance the photoelectric conversion efficiency.

In the embodiment, back surface electrode layer 13 is provided on the entire surface of Mg-doped zinc oxide layer 12. Back surface electrode layer 13 can be made of a metal film of Cu (copper) or Ag (silver), for example. A Cu film is formed in the embodiment. The thickness of back surface electrode layer 13 is preferably in a range from 200 nm to 1000 nm inclusive, or more preferably in a range from 300 nm to 700 nm inclusive. By setting the thickness of back surface electrode layer 13 within any of the above-mentioned ranges, the photoelectric conversion body can collect the carriers more efficiently while reducing losses thereof.

Furthermore, an interface between Mg-doped zinc oxide layer 12 and back surface electrode layer 13 functions as a reflection layer configured to reflect the light passing through crystalline semiconductor substrate 2. Accordingly, by using Mg-doped zinc oxide layer 12 with a high degree of transparency and low optical absorptance, it is possible to increase an amount of light incident onto the photoelectric conversion body and to improve the short-circuit current (Isc) of solar cell 1.

Light-receiving surface electrode layer 9 is made of a material having conductivity as well as translucency or transparency. Specifically, metal oxides such as indium oxide, tin oxide, zinc oxide and titanium oxide are usable. Such a metal oxide may further be doped with a dopant such as W (tungsten), Sn (tin), Zn (zinc), Sb (antimony), Ti (titanium), Ce (cerium), and Ga (gallium). An indium oxide film is particularly preferable as the metal oxide layer.

In the embodiment, light-receiving surface electrode 9 is made of a W-doped indium oxide layer. The W content in the W-doped indium oxide layer is preferably in a range from 0.3 at% to 5 at% inclusive, or more preferably in a range from 0.5 at% to 2 at% inclusive. By setting the W content within any of the above-mentioned ranges, it is possible to suppress an increase in electrical resistance while inhibiting absorption of the incident light.

The thickness of light-receiving surface electrode layer 9 is preferably in a range from 50 nm to 150 nm inclusive, or more preferably in a range from 70 nm to 120 nm inclusive. By setting the thickness of light-receiving surface electrode layer 9 within any of the above-mentioned ranges, it is possible to suppress an increase in electrical resistance while inhibiting absorption of the incident light.

Finger electrodes 10 can be formed by a general method of forming finger electrodes in a solar cell. For example, finger electrodes 10 can be formed by printing with Ag (silver) paste. A bus bar electrode to intersect finger electrodes 10 may also be formed. Nonetheless, finger electrodes 10 may be made bus-bar-less without being provided with a bus bar electrode.

The layers of solar cell 1 can be formed as described below. First, surfaces of crystalline silicon substrate 2 are preferably cleaned prior to the formation of the layers. Specifically, the cleaning can be achieved by using a hydrofluoric acid solution or a RCA cleaning solution. In addition, it is preferable to form texture structures on a surface and/or a back surface of crystalline silicon substrate 2 by using an alkaline etchant such as a potassium hydroxide aqueous solution (KOH aqueous solution). In this case, a texture structure having a pyramid-shaped (111) plane can be formed by subjecting crystalline silicon substrate 2 having a (100) plane to anisotropic etching with the alkaline etchant. In the meantime, an oxidized interface may be formed by conducting a given oxidation treatment prior to the formation of amorphous silicon film 5 and amorphous silicon film 7 for the purpose of improving conformity with amorphous silicon film 5 and amorphous silicon film 7. As the oxidation treatment, crystalline silicon substrate 2 may be left for a predetermined time period in the air or a humidity-controlled atmosphere. Alternatively, any of an ozone water treatment, a hydrogen peroxide treatment, an ozonizer treatment, and the like may be used as appropriate.

Each of amorphous silicon films 5 to 8 can be formed by a method such as plasma chemical vapor deposition, thermal chemical vapor deposition, photochemical vapor deposition, and sputtering. The plasma chemical vapor deposition may employ any methods including a RF plasma method, a VHF plasma method, a microwave plasma method, and the like. In the case of using the RF plasma chemical vapor deposition, for instance, the amorphous silicon films can be formed by: supplying one or more of a silicon-containing gas such as silane (SiH₄), a p-type dopant-containing gas such as diborane (B₂H₆), and an n-type dopant-containing gas such as phosphine (PH₃) as appropriate while diluting the gases with hydrogen; converting the gases into plasma by applying RF power to parallel flat-plate electrodes and the like; and supplying the plasma onto the surface of heated crystalline silicon substrate 2. Here, the temperature of the substrate at the time of the film formation is preferably in a range from 150°C to 250°C. Meanwhile, the RF power density at the time of the film formation is preferably in a range from 1 mW/cm² to 10 mW/cm².

Each of contact layer 11, Mg-doped zinc oxide layer 12, and light-receiving surface electrode layer 9 can be formed by a thin-film formation method such as sputtering, vapor deposition, and chemical vapor deposition.

Back surface electrode layer 13 can be formed by a thin-film formation method such as sputtering, vapor deposition, chemical vapor deposition, printing, and plating.

In the embodiment, the intrinsic amorphous silicon film is provided between the crystalline silicon substrate and the first amorphous silicon film, as well as between the crystalline silicon substrate and the second amorphous silicon film. However, the invention is not limited to this configuration. The first amorphous silicon film or the second amorphous silicon film may be provided directly on the crystalline silicon substrate.

Although the embodiment describes the example in which the one conductivity type is the n-type while the other conductivity type is the p-type, the invention is not limited to this configuration and the one conductivity type may be the p-type while the other conductivity type may be the n-type. In the meantime, the embodiment describes the example in which the conductivity type of crystalline silicon substrate 2 is the n-type, namely, the one conductivity type. However, the invention is not limited to this configuration and the conductivity type of crystalline silicon substrate 2 may be of the p-type, namely, the other conductivity type.

## Claims

1. A solar cell comprising:
a crystalline silicon substrate including a first principal surface, and a second principal surface provided on an opposite side from the first principal surface;
a first amorphous silicon layer provided on the first principal surface side;
a second amorphous silicon layer provided on the second principal surface side;
a contact layer in contact with the second amorphous silicon layer;
a magnesium-doped zinc oxide layer in contact with the contact layer;
a first electrode layer provided on the first amorphous silicon layer; and
a second electrode layer provided on the magnesium-doped zinc oxide layer, wherein
a lattice constant of the contact layer is within a range of plus or minus 30% relative to a lattice constant of the magnesium-doped zinc oxide layer.

2. The solar cell according to claim 1, wherein the contact layer is a zinc oxide layer.

3. The solar cell according to claim 2, wherein a thickness of the contact layer is in a range from 10 nm to 80 nm inclusive.

4. The solar cell according to claim 2 , wherein the zinc oxide layer is a gallium-doped zinc oxide layer.

5. The solar cell according to any one of claims 1 to 4, wherein the second electrode layer is a metal film provided on the entire surface of the magnesium-doped zinc oxide layer.

6. The solar cell according to any one of claims 1 to 5, wherein the first electrode layer is an indium oxide layer.

7. The solar cell according to claim 6, wherein the indium oxide layer is made of tungsten-doped indium oxide.

8. The solar cell according to any one of claims 1 to 7, wherein an intrinsic amorphous silicon layer is provided at least any one of between the first amorphous silicon layer and the crystalline silicon substrate, and between the second amorphous silicon layer and the crystalline silicon substrate.
